(19)

Europäisches
Patentamt
European
Patent Office
Office européen
des brevets

(11) **EP 3 156 440 A1**

(12) # EUROPEAN PATENT APPLICATION
published in accordance with Art. 153(4) EPC

(43) Date of publication:
**19.04.2017 Bulletin 2017/16**

(21) Application number: **15805925.3**

(22) Date of filing: **15.04.2015**

(51) Int Cl.:
*C08K 3/22* (2006.01)          *C08K 3/10* (2006.01)
*C08L 101/00* (2006.01)          *H01L 33/56* (2010.01)

(86) International application number:
**PCT/KR2015/003794**

(87) International publication number:
**WO 2015/190684 (17.12.2015 Gazette 2015/50)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA**

(30) Priority: **12.06.2014 KR 20140071454**

(71) Applicant: **Hyosung Corporation**
**Seoul 121-720 (KR)**

(72) Inventors:
• **GO, Da Hyun**
**Seoul 140-773 (KR)**

• **KIM, Young Sic**
**Seoul 134-769 (KR)**
• **RYU, Jeong Gon**
**Hwaseong-si**
**Gyeonggi-do 445-793 (KR)**
• **IM, Seo Young**
**Seoul 137-878 (KR)**
• **WON, Kyung Ill**
**Bucheon-si**
**Gyeonggi-do 421-180 (KR)**
• **PARK, Kwang Jin**
**Incheon 405-825 (KR)**

(74) Representative: **Patentanwaltskanzlei Hübscher**
**Spittelwiese 4**
**4020 Linz (AT)**

(54) **LED ENCAPSULANT COMPRISING RARE EARTH METAL OXIDE PARTICLES**

(57)    The present invention relates to an LED encapsulant including rare-earth metal oxide particles and, more particularly, to an LED encapsulant including a compound represented by Chemical Formula 1 below in a polymer resin.

[Chemical Formula 1]          $M_a(OH)_b(CO_3)_cO_d$

In Chemical Formula 1, M is Sc, Y, La, Al, Lu, Ga, Zn, V, Zr, Ca, Sr, Ba, Sn, Mn, Bi or Ac, a is 1 or 2, b is 0 to 2, c is 0 to 3, and d is 0 to 3, wherein b, c, and d are not simultaneously zero, and b and c are either simultaneously zero or simultaneously not zero.

FIG. 1

## Description

## Technical Field

The present invention relates to an LED (Light-Emitting Diode) encapsulant including rare-earth metal oxide particles.

## Background Art

An LED, which is a light-emitting element and is a type of semiconductor used to transmit and receive a signal by converting electricity into infrared rays or light using the characteristics of compound semiconductors, has been widely utilized as an illuminator or backlight for display devices due to advantages of high efficiency, a highspeed response, a long lifespan, small size and weight, and low electrical power consumption. The advanced application of LEDs in response to the global trend towards saving energy and the development of compound semiconductor technologies has led to the rapid industrialization of LEDs.

Typically, an LED package broadly includes an LED chip, an adhesive, an encapsulant, a phosphor, and heat-dissipation component. Among them, the LED encapsulant surrounds the LED chip, thus protecting the LED chip from external impacts and the environment.

However, since the LED light must pass through the LED encapsulant in order to be emitted from the LED package, the LED encapsulant must have high optical transparency, that is, high light transmittance, and is also required to have a high refractive index suitable for increasing light extraction efficiency.

An epoxy resin having a high refractive index and low cost has been widely used as the LED encapsulant. However, the epoxy resin has low heat resistance and may thus be deteriorated by the heat of high-power LEDs. Further, the epoxy resin suffers from decreased luminance due to yellowing caused by light near ultraviolet rays and blue light from white LEDs.

As an alternative thereto, silicone resin, having excellent light resistance in a low-wavelength range, is being used (the bonding energy of the siloxane bond (Si-O-Si) of the silicone resin is 106 kcal/mol, which is at least 20 kcal/mol higher than carbon-carbon (C-C) bonding energy, and accordingly, silicone resin is excellent in terms of heat resistance and light resistance). However, silicone resin has poor adhesion and reduced light extraction efficiency due to its low refractive index.

Conventional techniques for encapsulants may be understood with reference to the following Patent Documents 1 and 2. Here, the entire contents of the following Patent Documents 1 and 2, as conventional techniques, are incorporated in the present specification.

Patent Document 1 discloses a curable liquid polysiloxane/$TiO_2$ composite to be used as an encapsulant for an LED, which includes a polysiloxane prepolymer having a $TiO_2$ domain with an average domain size of less than 5 nm, which contains 20 to 60 mol% of $TiO_2$ (based on total solids), which has a refractive index of between 1.61 and 1.7, and which is in a liquid state at room temperature and atmospheric pressure.

Patent Document 2 discloses a composition for an encapsulant of an optoelectronic device, which includes an epoxy resin and polysilazane undergoing a curing reaction with the epoxy resin, an encapsulant formed using the composition, and an LED including the encapsulant.

[Prior Art Documents]

[Patent Literature]

(Patent Document 1) Korean Patent Application Publication No. 10-2012-0129788 A (November 28, 2012)
(Patent Document 2) Korean Patent Application Publication No. 10-2012-0117548 A (October 24, 2012)

## Disclosure

## Technical Problem

There are largely two methods for increasing the luminous efficiency of an LED.

The first method involves increasing the total quantity of light generated from a chip.

The second method includes emitting as much of the generated light as possible to the outside of the LED to thus increase the so-called light extraction efficiency.

As described above, a typical LED package includes an LED chip surrounded by an encapsulant, but only about 15% of the luminous energy generated in the chip is emitted in the form of light, and the remainder is absorbed by the encapsulant and the like.

Accordingly, in view of the luminous efficiency of LEDs, interest is being focused on improving light extraction efficiency so that the light generated in the light-emitting layer of the LED is effectively emitted to the outside without loss caused by total reflection in the LED chip.

Currently, various technologies are being studied to increase the light extraction efficiency so as to emit as much light as possible to the outside of the LED. However, there is still a need for further improvement.

Accordingly, the present invention is intended to provide an encapsulant composition that dramatically improves light extraction efficiency.

## Technical Solution

Therefore, the present invention has been made keeping in mind the above problems encountered in the prior art, and the present invention provides an LED encapsulant comprising a compound represented by Chemical Formula 1 below in a polymer resin.

[Chemical Formula 1] $\quad\quad M_a(OH)_b(CO_3)_cO_d$

wherein, M is Sc, Y, La, Al, Lu, Ga, Zn, V, Zr, Ca, Sr, Ba, Sn, Mn, Bi or Ac, a is 1 or 2, b is 0 to 2, c is 0 to 3, and d is 0 to 3. However, b, c, and d are not simultaneously zero, and b and c are either simultaneously zero or simultaneously not zero.

Also, the present invention provides an LED encapsulant in which the compound represented by Chemical Formula 1 may be $Y(OH)CO_3$.

Also, the present invention provides an LED encapsulant in which the compound represented by Chemical Formula 1 may be $Y_2O_3$.

Also, the present invention provides an LED encapsulant in which the compound represented by Chemical Formula 1 may have a refractive index ranging from 1.6 to 2.3.

Also, the present invention provides an LED encapsulant in which the polymer resin is at least one selected from the group consisting of a silicone-based resin, a phenol-based resin, an acrylic resin, polystyrene, polyurethane, a benzoguanamine resin, and an epoxy-based resin.

Also, the present invention provides an LED encapsulant which further includes phosphor particles.

## Advantageous Effects

According to the present invention, the encapsulant composition is effective at drastically improving the extraction efficiency of light generated in an LED chip.

## Description of Drawings

FIG. 1 is an SEM (Scanning Electron Microscope) image showing rare-earth oxide particles ($Y(OH)CO_3$ particles) according to the present invention; and

FIG. 2 is an SEM image showing rare-earth oxide particles ($Y_2O_3$ particles) according to the present invention.

## Mode for Invention

Hereinafter, a detailed description will be given of the present invention.

The present invention pertains to a resin and a rare-earth metal oxide additive for use in encapsulation of an LED package exhibiting improved light extraction efficiency and, more particularly, to a resin for an LED encapsulant including rare-earth metal oxide nanoparticles, which serves to extract light rays that are confined between an LED package chip and an encapsulant, among the light rays generated in an LED package, to the outside, thereby manifesting high luminous efficiency.

Accordingly, the present invention comprises a compound represented by Chemical Formula 1 below in a polyer resin.

[Chemical Formula 1] $\quad\quad M_a(OH)_b(CO_3)_cO_d$

wherein, M is Sc, Y, La, Al, Lu, Ga, Zn, V, Zr, Ca, Sr, Ba, Sn, Mn, Bi or Ac. a is 1 or 2, b is 0 to 2, c is 0 to 3, and d is 0 to 3.

Here, b, c, and d are not simultaneously zero, and b and c are either simultaneously zero or simultaneously not zero.

The compound of Chemical Formula 1 is preferably $Y(OH)CO_3$ or $Y_2O_3$, and more preferably $Y(OH)CO_3$ with respect to light extraction efficiency. This may be understood in greater detail through the Examples and Experimental Example, which will be described hereafter.

It is preferable for the compound of Chemical Formula 1 to have a refractive index in the range of 1.6 to 2.3. If the refractive index is less than 1.6 or greater than 2.3, light extraction efficiency may not be increased. The reason is that the refractive index of a typical silicone encapsulant is about 1.5 and the refractive index of a GaN chip is about 2.4.

In a light-emitting element package chip, total reflection occurs at boundaries between the element and external air or silicone which is an external encapsulant, or the like. According to Snell's law, the critical angle ($\theta$crit) at which the light or waves passing through two isotropic media having different refractive indices can be emitted from the media to the outside is obtained using the following Equation.

$$\theta crit = arcsin\left(\frac{n2}{n1}\right)$$

The refractive index of GaN is about 2.5, which is largely different from that of air ($n_{air}$ = 1) and silicone ($n_{silicone}$ = 1.5). Accordingly, the critical angle at which light generated in the light-emitting element package can be emitted to the outside is limited ($\theta_{GaN/air}$ = 23° and $\theta_{GaN/silicone}$ = 37°, respectively). Therefore, light extraction efficiency is only about 15%.

The polymer resin is not particularly limited, so long as polymer resin widely used in the art is used. For example, at least one selected from among a silicone-based resin, a phenol-based resin, an acrylic resin, polystyrene, polyurethane, a benzoguanamine resin, and an epoxy-based resin may be used. The silicone-based resin may be any one selected from among polysilane, polysiloxane, and a combination thereof. The phenol-based resin may be at least one phenol resin selected from among a bisphenol-type phenol resin, a resol-type phenol resin, and a resol-type naphthol resin. The epoxy-based resin may be at least one epoxy resin selected from among bisphenol F-type epoxy, bisphenol A-type epoxy, phenol novolak-type epoxy, and cresol novolak-type epoxy.

The encapsulant composition according to the present invention may further include phosphor particles so as to exhibit a desired color.

The present invention is described in more detail through the following examples, which are set forth to illustrate, but are not to be construed to limit the scope of the present invention.

**Examples**

Example 1

$Y(OH)CO_3$ particles were manufactured with 100 mL of distilled water as the standard. Specifically, 2 g of yttrium nitrate hydrate and 40 g of urea were dissolved in 100 mL of distilled water and then mixed by sufficiently stirring for 30 min. After stirring, the pH of the resulting solution was adjusted to 5 to 6 using nitric acid and ammonium hydroxide as a base. The mixed solution was heated to 90°C and stirred for 1 hr, filtered, and washed three times with distilled water. The washed $Y(OH)CO_3$ particles were dried in an oven at 70°C for 3 hrs, to manufacture particles having a size of 200 nm or less.

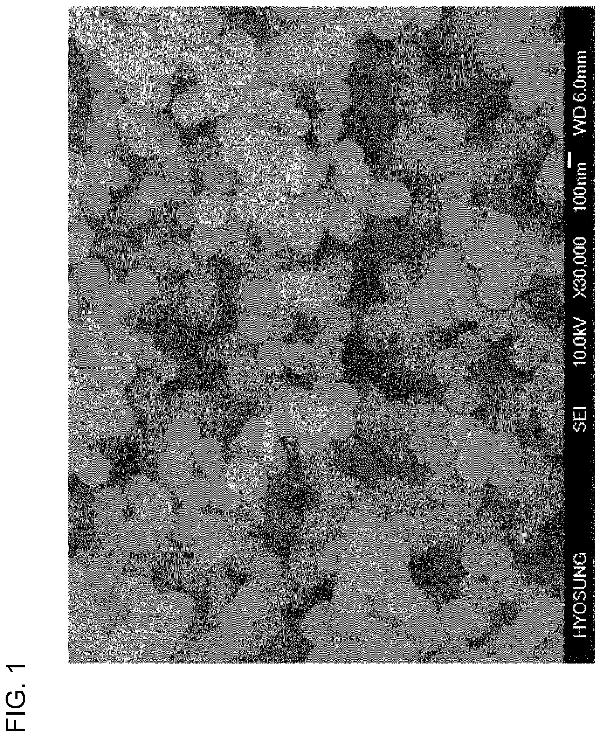

FIG. 1 shows an SEM image of the manufactured particles.

The $Y(OH)CO_3$ particles were added to a silicone-based resin (a mixture comprising OE 6631 A and OE 6631 B at a ratio of 1:2) (97 wt% of the silicone-based resin and 3 wt% of the $Y(OH)CO_3$), after which the resulting mixture was placed in a homogenizer and homogenized, to prepare an encapsulant composition.

Example 2

$Y_2O_3$ particles were obtained by manufacturing and then firing $Y(OH)CO_3$. 100 mL of distilled water was used as a standard for $Y(OH)CO_3$. Specifically, 2 g of yttrium nitrate hydrate and 40 g of urea were dissolved in 100 mL of distilled water and then mixed by sufficiently stirring for 30 min. After stirring, the pH of the resulting solution was adjusted to 5 to 6 using nitric acid and ammonium hydroxide as a base. The mixed solution was heated to 90°C and stirred for 1 hr, filtered, and washed three times with distilled water. The washed $Y(OH)CO_3$ particles were dried in an oven at 70°C for 3 hrs. Then the dried $Y(OH)CO_3$ particles were fired at 900°C for 3 hrs in an oxidizing atmosphere, to obtain $Y_2O_3$

particles having a size of 200 nm or less.

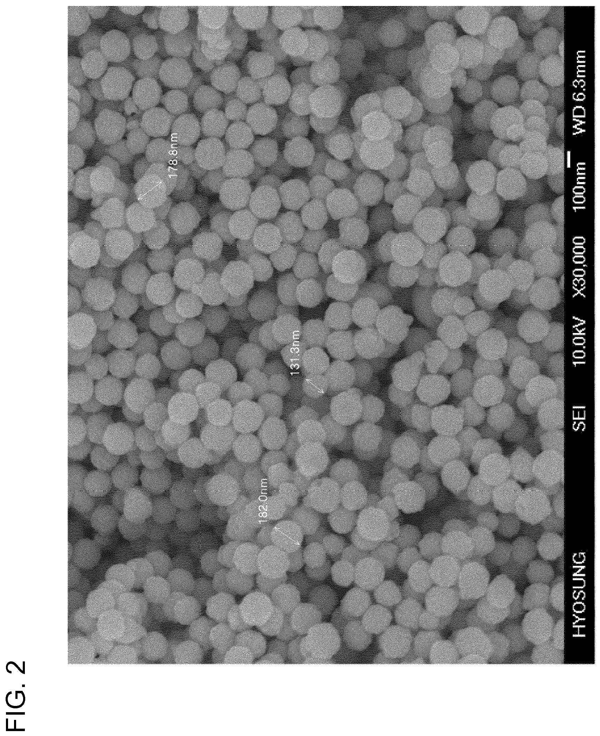

FIG. 2 shows an SEM image of the manufactured particles.

The $Y_2O_3$ particles were added to a silicone-based resin (a mixture comprising OE 6631 A and OE 6631 B at a ratio of 1:2) (97 wt% of the silicone-based resin and 3 wt% of the $Y_2O_3$), after which the resulting mixture was placed in a homogenizer and homogenized, to prepare an encapsulant composition.

**Comparative Example**

A 100 wt% encapsulant composition was prepared by mixing a silicone-based resin OE 6631 A and OE 6631 B at a ratio of 1:2.

**Experimental Example**

The encapsulant compositions of Examples 1 and 2 and Comparative Example were mounted in an LED package having a blue LED (a wavelength of 450 nm) chip, and then the rate of increase in luminance was measured. In the LED package, the chip connected on a lead frame through die bonding was used as a light-emitting source. The LED package is configured such that the LED and the lead frame are electrically connected through metal wire bonding and then molded with an encapsulant consisting of a silicone resin, which is material for transparent encapsulant, and inorganic nanoparticles dispersed therein. As for the luminance increase rate, the degree of increase in luminance compared with the Comparative Example was expressed as a percentage. Luminance was measured using a DARSA Pro 5200 PL system from the Professional Scientific Instrument Company, Korea.

The results are given in Table 1 below.

[Table 1]

| | Comparative Example | Example 1 | Example 2 |
|---|---|---|---|
| Luminance increase rate (%) | 0 | 5.9 | 2.6 |

As is apparent from Table 1, when the rare-earth metal oxide inorganic particles were contained in the encapsulant composition, the luminance was found to be drastically increased. Particularly, in the case of $Y(OH)CO_3$ particles, when the amount of the particles was 3 wt%, luminance was increased by more than about two times compared to the same amount of $Y_2O_3$ particles.

**Claims**

1. An LED (Light-Emitting Diode) encapsulant, comprising a compound represented by Chemical Formula 1 below in a polymer resin.

[Chemical Formula 1]    $M_a(OH)_b(CO_3)_cO_d$

   wherein M is Sc, Y, La, Al, Lu, Ga, Zn, V, Zr, Ca, Sr, Ba, Sn, Mn, Bi or Ac,
   a is 1 or 2,
   b is 0 to 2,
   c is 0 to 3, and
   d is 0 to 3,
   wherein b, c, and d are not simultaneously zero, and b and c are either simultaneously zero or simultaneously not zero.

2. The LED encapsulant of claim 1, wherein the compound represented by Chemical Formula 1 is $Y(OH)CO_3$.

3. The LED encapsulant of claim 1, wherein the compound represented by Chemical Formula 1 is $Y_2O_3$.

4. The LED encapsulant of claim 1, wherein the compound represented by Chemical Formula 1 has a refractive index ranging from 1.6 to 2.3.

5. The LED encapsulant of claim 1, wherein the polymer resin is least one selected from the group consisting of a silicone-based resin, a phenol-based resin, an acrylic resin, polystyrene, polyurethane, a benzoguanamine resin, and an epoxy-based resin.

6. The LED encapsulant of claim 1, further comprising phosphor particles.

FIG. 1

FIG. 2

## INTERNATIONAL SEARCH REPORT

| International application No. |
| --- |
| **PCT/KR2015/003794** |

### A. CLASSIFICATION OF SUBJECT MATTER

*C08K 3/22(2006.01)i, C08K 3/10(2006.01)i, C08L 101/00(2006.01)i, H01L 33/56(2010.01)i*

According to International Patent Classification (IPC) or to both national classification and IPC

### B. FIELDS SEARCHED

Minimum documentation searched (classification system followed by classification symbols)
C08K 3/22; C08L 83/04; H01L 51/50; H01L 33/52; H05B 33/04; C08G 77/20; C08K 3/10; C08L 101/00; H01L 33/56

Documentation searched other than minimum documentation to the extent that such documents are included in the fields searched
Korean Utility models and applications for Utility models: IPC as above
Japanese Utility models and applications for Utility models: IPC as above

Electronic data base consulted during the international search (name of data base and, where practicable, search terms used)
eKOMPASS (KIPO internal) & Keywords: LED encapsulation, rare earth metal oxide, polymer resin

### C. DOCUMENTS CONSIDERED TO BE RELEVANT

| Category* | Citation of document, with indication, where appropriate, of the relevant passages | Relevant to claim No. |
| --- | --- | --- |
| X | JP 2013-232279 A (HITACHI LTD.) 14 November 2013<br>See claims 1, 3, 8, 9 | 1,3-5 |
| A | | 2,6 |
| X | KR 10-2007-0069669 A (SUKGYUNG AT CO., LTD.) 03 July 2007<br>See abstract; claims 1, 5; paragraph [0025] | 1,3,5,6 |
| X | KR 10-2014-0034122 A (DOW CORNING CORPORATION et al.) 19 March 2014<br>See claims 1, 6, 7 | 1 |
| X | KR 10-2013-0140815 A (DOW CORNING CORPORATION) 24 December 2013<br>See paragraph [0109], claims 1, 17 | 1 |

☐ Further documents are listed in the continuation of Box C.   ☒ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 06 JULY 2015 (06.07.2015) | **07 JULY 2015 (07.07.2015)** |

| Name and mailing address of the ISA/**KR** | Authorized officer |
| --- | --- |
| Korean Intellectual Property Office<br>Government Complex-Daejeon, 189 Seonsa-ro, Daejeon 302-701,<br>Republic of Korea | |
| Facsimile No. 82-42-472-7140 | Telephone No. |

Form PCT/ISA/210 (second sheet) (July 2009)

INTERNATIONAL SEARCH REPORT
Information on patent family members

International application No.

**PCT/KR2015/003794**

| Patent document cited in search report | Publication date | Patent family member | Publication date |
|---|---|---|---|
| JP 2013-232279 A | 14/11/2013 | TW 201217444 A<br>WO 2012-014629 A1 | 01/05/2012<br>02/02/2012 |
| KR 10-2007-0069669 A | 03/07/2007 | NONE | |
| KR 10-2014-0034122 A | 19/03/2014 | CN 103314038 A<br>JP 2014-505748 A<br>US 2013-0256742 A1<br>WO 2012-078582 A1 | 18/09/2013<br>06/03/2014<br>03/10/2013<br>14/06/2012 |
| KR 10-2013-0140815 A | 24/12/2013 | CN 103370360 A<br>JP 2014-506263 A<br>US 2013-0256741 A1<br>WO 2012-078594 A1 | 23/10/2013<br>13/03/2014<br>03/10/2013<br>14/06/2012 |

Form PCT/ISA/210 (patent family annex) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020120129788 A

- KR 1020120117548 A